(19) Europäisches Patentamt / European Patent Office / Office européen des brevets

(11) **EP 3 279 372 B1**

(12) **EUROPÄISCHE PATENTSCHRIFT**

(45) Veröffentlichungstag und Bekanntmachung des Hinweises auf die Patenterteilung:
**07.09.2022 Patentblatt 2022/36**

(21) Anmeldenummer: **17182948.4**

(22) Anmeldetag: **25.07.2017**

(51) Internationale Patentklassifikation (IPC):
**C30B 13/30** $^{(2006.01)}$    **C30B 13/28** $^{(2006.01)}$

(52) Gemeinsame Patentklassifikation (CPC):
**C30B 13/30; C30B 13/28**

(54) **VERFAHREN ZUR HERSTELLUNG EINES EINKRISTALLS DURCH ZONENSCHMELZEN**

METHOD FOR THE PRODUCTION OF A SINGLE CRYSTAL BY ZONE MELTING

PROCÉDÉ DE FABRICATION D'UN MONOCRISTAL PAR FUSION DE ZONE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.08.2016 DE 102016214581**

(43) Veröffentlichungstag der Anmeldung:
**07.02.2018 Patentblatt 2018/06**

(73) Patentinhaber: **Siltronic AG
81677 München (DE)**

(72) Erfinder:
- **Frank, Mümmler
84453 Mühldorf am Inn (DE)**
- **Zwirglmaier, Hermann
84576 Teising (DE)**
- **Berger, Josef
84571 Reischach (DE)**

(74) Vertreter: **Staudacher, Wolfgang
Siltronic AG
Intellectual Property -LP 244
Johannes-Hess-Str. 24
84489 Burghausen (DE)**

(56) Entgegenhaltungen:
**EP-A1- 0 294 311    JP-A- H11 278 981**

- **CHAN Y T ET AL: "COMPUTER-CONTROLLED FLOAT ZONE CRYSTAL GROWTH", REVIEW OF SCIENTIFIC INSTRUMENTS, AIP, MELVILLE, NY, US, Bd. 64, Nr. 9, 1. September 1993 (1993-09-01), Seiten 2643-2649, XP000395646, ISSN: 0034-6748, DOI: 10.1063/1.1143884**

**Beschreibung**

Gegenstand der Erfindung ist ein Verfahren zur Herstellung eines Einkristalls durch Zonenschmelzen, umfassend das Kristallisieren von geschmolzenem Material auf einem Keimkristall unter Bildung eines wachsenden Einkristalls, das Drehen des wachsenden Einkristalls, das Erzeugen einer auf dem wachsenden Einkristall liegenden Schmelzzone durch Schmelzen von festem Material in Gegenwart einer Induktionsheizspule und das Aufnehmen mit einer Kamera von Bildern umfassend einen Teil der Schmelzzone.

Einkristalle, insbesondere solche aus Silizium, werden in der Regel in industriellem Maßstab hergestellt durch Ziehen aus einem Tiegel (CZ-Verfahren) oder durch Zonenschmelzen (FZ-Verfahren). In beiden Fällen ist es üblich, das Kristallwachstum mittels einer Kamera zu beobachten.

In EP0 294 311 A1 ist ein Verfahren zur automatischen Regelung des Durchmessers des Einkristalls beschrieben.

JP11-278 981 A beschreibt die Herstellung eines Einkristalls aus Halbleitermaterial nach dem FZ-Verfahren, wobei Ziehkanten des wachsenden Einkristalls mittels einer Kamera beobachtet werden und das Verschwinden der Ziehkanten signalisiert, dass weiteres einkristallines Wachstum nicht mehr möglich ist.

CHAN et al. (CHAN Y. T., "COMPUTER-CONTROLLED FLOAT ZONE CRYSTAL GROWTH", REVIEW OF SCIENTIFIC INSTRUMENTS, AIP, MELVILLE, NY, US, Bd. 64, Nr. 9, 1. September 1993 (1993-09-01), Seiten 2643-2649, ISSN: 0034-6748, DOI: 10.1063/1.1143884) beschreiben die Vorteile einer computergestützten Prozesskontrolle gegenüber einer manuellen Kontrolle bei Ziehen von Einkristallen nach dem FZ-Verfahren.

In JP9-208381 A wird empfohlen, während des Ziehens eines Einkristalls nach dem CZ-Verfahren den Grenzbereich zwischen der Schmelze und dem wachsenden Einkristall zu beobachten, um die Bildung von Versetzungen automatisch zu erkennen. Haben sich Versetzungen gebildet, werden Ziehkanten (ridges), die ein Einkristall auf Grund der Orientierung seines Kristallgitters am Umfang aufweist, nicht mehr beobachtet. Beispielsweise haben Einkristalle aus Silizium mit <100>-Orientierung vier Ziehkanten, solche mit <111>-Orientierung drei Ziehkanten.

Aufgabe der vorliegenden Erfindung ist es, die Herstellung eines Einkristalls durch Zonenschmelzen dahingehend zu verbessern, dass Störungen des Wachstums des Einkristalls möglichst frühzeitig erkannt werden und dass auf solche Störungen angemessen reagiert werden kann.

Gelöst wird die Aufgabe durch ein Verfahren gemäß der Ansprüche 1 und 2.

Die Erfindung ist insbesondere zur Herstellung von Einkristallen aus Silizium geeignet, aber nicht auf dieses Material beschränkt. Sie kann beispielsweise auch eingesetzt werden, um Einkristalle aus Halbleitermaterial herzustellen, die Silizium und Germanium, Germanium oder Elemente von Verbindungshalbleitern enthalten. Der Durchmesser der Einkristalle beträgt vorzugsweise nicht weniger als 150 mm, besonders bevorzugt nicht weniger als 200 mm.

Das erfindungsgemäße Verfahren umfasst das Schmelzen von Vorrat (feed) in Form von Stäben (rods), aber auch in Form von Granulat oder Bruchstücken (chunks).

Der Bildsensor der Kamera ist vorzugsweise ein CCD-Sensor oder ein CMOS-Sensor.

Das Erzeugen eines Warnsignals kann eine angemessene Reaktion auf ein Ereignis sein, das eine Störung des Wachstums des Einkristalls bewirkt. Eine solche Reaktion kommt insbesondere in Betracht, wenn die Störung als weniger schwerwiegend angesehen wird und ein Operator auf Grund des Warnsignals gegebenenfalls noch korrigierend eingreifen kann. Bei schwerwiegenderen Störungen, vor allem solchen, auf Grund derer Versetzungen gebildet werden, ist es eher angemessen, unverzüglich dafür zur sorgen, dass das Kristallwachstum abgebrochen wird.

Es gibt ein nicht erfindungsgemäßes Verfahren zur Herstellung eines Einkristalls durch Zonenschmelzen, umfassend

das Kristallisieren von geschmolzenem Material auf einem Keimkristall unter Bildung eines wachsenden Einkristalls;
das Drehen des wachsenden Einkristalls mit einer Drehzahl;
das Erzeugen und Erhalten einer auf dem wachsenden Einkristall liegenden Schmelzzone durch Schmelzen von festem Material in Gegenwart einer Induktionsheizspule;
das Aufnehmen mit einer Kamera und mit einer Taktfrequenz von Bildern umfassend die Schmelzzone, wobei die Verwendung bestimmter Paar-Kombinationen der Drehzahl und der Taktfrequenz abhängig von einer Orientierung des Kristallgitters des wachsenden Einkristalls ausgeschlossen wird;
das Bestimmen des Durchmessers des wachsenden Einkristalls durch Auswerten eines Bildausschnitts der aufgenommenen Bilder umfassend den Grenzbereich zwischen Schmelzzone und wachsenden Einkristall; und
das Erzeugen eines Warnsignals und/oder das Bewirken des Abbruchs des Kristallwachstums, sobald der Durchmesser des wachsenden Einkristalls oder eine davon abgeleitete Messgröße die diesbezüglich gesetzte Schwelle passiert.

Es wurde festgestellt, dass beim FZ-Verfahren Fehlalarme entstehen können, weil Ziehkanten zeitweise nicht beobachtet werden, obwohl keine Versetzungsbildung stattgefunden hat.

Dieses Verfahren hat insbesondere die folgenden Vorteile: Störungen des Wachstums des Einkristalls, die die Bildung von Versetzungen auslösen, werden zuverlässig erkannt und es kann angemessen auf solche Störungen reagiert werden. Fehlalarme, die fälschlicherweise die Bildung von Versetzungen anzeigen, werden vermieden.

Dieses Verfahren umfasst das Drehen des wachsenden Einkristalls mit einer bestimmten Drehzahl, wobei die Drehrichtung in zeitlichen Abständen gewechselt werden kann, und das Aufnehmen mittels einer Kamera von Bildern umfassend den Grenzbereich zwischen Schmelzzone und wachsenden Einkristall. Die Bilder werden mit einer bestimmten Taktfrequenz aufgenommen. Dabei werden die Drehzahl des Einkristalls und die Taktfrequenz der Bildaufnahmen so aufeinander abgestimmt, dass folgende Regel (1) erfüllt ist, wobei DZ die Drehzahl des wachsenden Einkristalls in Umdrehungen pro Minute, TF die Taktfrequenz der Kamera in Bilder pro Sekunde und ZK die Anzahl der Ziehkanten des Einkristalls bedeuten:

$$60 \, / \, (DZ \times TF \times ZK) \notin \mathbb{N} \qquad\qquad (1)$$

Bei gegebener Taktfrequenz der Bildaufnahmen werden also solche Drehzahlen des wachsenden Einkristalls ausgeschlossen, bei denen die Auswertung der linken Seite von Regel (1) eine ganze Zahl ergeben würde. Mit dem Ausschluss solcher Drehzahlen wird die Situation vermieden, dass die Drehgeschwindigkeit des Einkristalls und die Taktfrequenz der Kamera derart synchronisiert sind, dass über einen längeren Zeitraum hinweg fälschlicherweise keine Ziehkanten beobachtet werden, obwohl sie vorhanden sind.

Die von der Kamera aufgenommenen Bilder werden einer digitalen Bildbearbeitung unterzogen und von einem Bildausschnitt, auf dem der Grenzbereich zwischen der Schmelzzone und dem wachsenden Einkristall abgebildet ist, der Durchmesser des wachsenden Einkristalls bestimmt. Der Durchmesser oder eine davon abgeleitete Messgröße wird daraufhin überprüft, ob er in einem Wertebereich liegt, der erwartet wird. Ist das nicht der Fall, weil er sich außerhalb gesetzter Schranken befindet, wird als Reaktion ein Warnsignal ausgegeben und/oder das weitere Wachstum des Einkristalls abgebrochen.

Die Auswertung der Bildausschnitte umfasst, dass die bestimmten Durchmesser-Werte laufend in einem Ringpuffer der Größe nach ansteigend sortiert gespeichert werden. Dem Median-Wert der gespeicherten Durchmesser-Werte wird der Durchmesser des wachsenden Einkristalls ohne Berücksichtigung von Ziehkanten zugeordnet und der Durchmesser des wachsenden Einkristalls mit Berücksichtigung von Ziehkanten beispielsweise dem 0,9 Quantil-Wert der gespeicherten Durchmesser-Werte. Dementsprechend drückt die Differenz des 0,9 Quantil-Werts und des Median-Werts den Anteil der Ziehkanten am Durchmesser des wachsenden Einkristalls aus. Diese Differenz wird vorzugsweise als Messgröße herangezogen, um zu überprüfen, ob eine Störung des Wachstums des Einkristalls stattgefunden hat. Unterschreitet der Wert der Messgröße eine gesetzte untere Schranke, wird das als Hinweis interpretiert, dass sich Versetzungen gebildet haben und das Kristallwachstum abgebrochen.

Gemäß einer ersten bevorzugten Ausführungsform der Erfindung wird die Aufgabe gelöst durch ein Verfahren zur Herstellung eines Einkristalls durch Zonenschmelzen, umfassend

das Kristallisieren von geschmolzenem Material auf einem Keimkristall unter Bildung eines wachsenden Einkristalls;
das Drehen des wachsenden Einkristalls mit einer Drehzahl;
das Erzeugen und Erhalten einer auf dem wachsenden Einkristall liegenden Schmelzzone durch Schmelzen von festem Material in Gegenwart einer Induktionsheizspule;
das Aufnehmen mit einer Kamera von Bildern umfassend einen Teil der Schmelzzone;
das Bestimmen einer Messgröße durch Auswerten eines Bildausschnitts der aufgenommenen Bilder; und
das Erzeugen eines Warnsignals als Reaktion auf ein Ereignis, das eine Störung des Wachstums des Einkristalls bewirkt und/oder das Bewirken des Abbruchs des Kristallwachstums, sobald die Messgröße eine diesbezüglich gesetzte Schwelle passiert, wobei das Verfahren des Weiteren umfasst
das Bestimmen einer Schwingungsamplitude der Schmelzzone durch Auswerten eines Bildausschnitts der aufgenommenen Bilder umfassend einen oberen Teil der Schmelzzone einschließlich eines Teils eines Halses der Schmelzzone und einen unteren Teil der Induktionsheizspule; und
das Erzeugen eines Warnsignals und/oder das Bewirken des Abbruchs des Kristallwachstums, sobald die Schwingungsamplitude die
diesbezüglich gesetzte Schwelle passiert, wobei zum Auswerten Grauwerte des Bildausschnittes eines Bilds mit denen eines Vorgängerbilds verglichen werden, der Betrag der Differenz der Grauwerte aufsummiert und normiert und als die Schwingungsamplitude der Schmelzzone interpretiert wird.

Das vorgeschlagene Verfahren gemäß der zweiten Ausführungsform der Erfindung hat insbesondere die folgenden Vorteile: Störungen des Wachstums des Einkristalls, insbesondere Ereignisse wie das Entstehen von Rissen im wachsenden Einkristall und das Abreißen des Halses der Schmelzzone, die die Bildung von Versetzungen auslösen, werden zuverlässig und besonders frühzeitig erkannt und es kann angemessen auf solche Störungen reagiert werden.

Bildausschnitte der Bilder, die von der Kamera aufgenommenen werden, werden einer digitalen Bildbearbeitung unterzogen und daraus eine Schwingungsamplitude der Schmelzzone bestimmt. Störungen des Wachstums des Einkristalls, wie die Bildung von Rissen im wachsenden Einkristall oder der Abriss des Halses der Schmelzzone verursachen eine Bewegung der Schmelzzone, die treffend als Zittern der Schmelzzone bezeichnet werden kann.

Die Auswertung der Bildausschnitte umfasst das Bestimmen der Grauwerte eines Bildausschnitts der Bilder, auf dem ein unterer Teil der Induktionsheizspule und ein oberer Teil der Schmelzzone einschließlich eines Halses der Schmelzzone abgebildet sind. Die Grauwerte des Bildausschnitts eines Bilds und des entsprechenden Bildausschnitts des Vorgängerbilds werden miteinander verglichen und der Betrag der Differenz der Grauwerte aufsummiert und normiert. Das Ergebnis wird als Schwingungsamplitude der Schmelzzone interpretiert und als Messwert herangezogen, um zu überprüfen, ob eine Störung des Wachstums des Einkristalls stattgefunden hat. Überschreitet der Messwert eine gesetzte obere Schranke, wird als Reaktion ein Warnsignal ausgegeben und/oder das weitere Wachstum des Einkristalls abgebrochen. Die obere Schranke kann derart gewählt werden, dass bei deren Überschreiten angenommen werden kann, dass sich im Einkristall Versetzungen, beispielsweise in Folge des Entstehens eines Risses, gebildet haben. In diesem Fall wird mit dem Abbruch des Kristallwachstums reagiert.

Gemäß einer zweiten bevorzugten Ausführungsform der Erfindung wird die Aufgabe gelöst durch ein Verfahren zur Herstellung eines Einkristalls durch Zonenschmelzen, umfassend

das Kristallisieren von geschmolzenem Material auf einem Keimkristall unter Bildung eines wachsenden Einkristalls;

das Drehen des wachsenden Einkristalls mit einer Drehzahl;

das Erzeugen und Erhalten einer auf dem wachsenden Einkristall liegenden Schmelzzone durch Schmelzen von festem Material in Gegenwart einer Induktionsheizspule;

das Aufnehmen mit einer Kamera von Bildern umfassend einen Teil der Schmelzzone;das Bestimmen einer Messgröße durch Auswerten eines Bildausschnitts der aufgenommenen Bilder; und

das Erzeugen eines Warnsignals auf ein Ereignis, das eine Störung des Wachstums des Einkristalls bewirkt und/oder das Bewirken des Abbruchs des Kristallwachstums, sobald die Messgröße eine diesbezüglich gesetzte Schwelle passiert, wobei das Verfahren des Weiteren umfasst

das Bestimmen des Abstands zwischen einer linksseitigen Kante des wachsenden Einkristalls und einem Referenzpunkt, der auf einer Achse durch die Mitte des Keimkristalls liegt, und des Abstands zwischen einer rechtsseitigen Kante des wachsenden Einkristalls und dem Referenzpunkt durch Auswerten eines Bildausschnitts der aufgenommenen Bilder umfassend einen Grenzbereich zwischen der Schmelzzone und dem wachsenden Einkristall und sobald die Amplitude einer Schwankung von mindestens einem der Abstände die diesbezüglich gesetzte Schwelle passiert,

das Erzeugen eines Warnsignals und/oder das Bewirken des Abbruchs des Kristallwachstums im Rahmen des Ausschöpfens eines Ermessensspielraums, der darin besteht einen Einkristall mit einer Fehlorientierung weiterwachsen zu lassen oder das Kristallwachstum abzubrechen.

Es gibt auch Störungen des Wachstums des Einkristalls, die gegebenenfalls einen Abbruch des Wachstumsvorgangs erforderlich machen, ohne dass die Bildung von Versetzungen stattgefunden hat. Eine solche Störung liegt beispielsweise vor, wenn die Achse durch die Mitte des wachsenden Einkristalls relativ zur Achse durch die Mitte des Keimkristalls gekippt wird. Diese Situation kann vorkommen, wenn ein Stützring an einen unteren konusförmigen Abschnitt des wachsenden Einkristalls zur Gewichtsentlastung angelegt wird und im Verlauf dessen auf Grund eines Fehlers eine Stützkraft auf den wachsenden Einkristall ausgeübt wird, die dessen Mittelachse aus der üblichen vertikalen Ausrichtung kippt. Bei einem vergleichsweise starken Kippen drohen das Ablaufen der Schmelzzone vom wachsenden Einkristall und ein Abriss des Halses der Schmelzzone, worauf mit dem Abbruch des Wachstumsvorgangs reagiert werden muss. Bei einem schwächeren Kippen wächst der Einkristall mit einer Orientierung des Kristallgitters, die von der des Keimkristalls abweicht. In dieser Situation besteht ein Ermessensspielraum, den Einkristall mit Fehlorientierung weiter wachsen zu lassen oder das Kristallwachstum abzubrechen.

Das vorgeschlagene Verfahren gemäß der zweiten Ausführungsform der Erfindung hat insbesondere die folgenden Vorteile: Auf Störungen des Wachstums des Einkristalls, die im Zusammenhang mit dem Kippen des wachsenden Einkristalls aus der vorgesehenen Lage stehen, werden zuverlässig und frühzeitig erkannt und es kann angemessen auf solche Störungen reagiert werden.

Die linksseitige Kante des wachsenden Einkristalls bezeichnet im ausgewerteten Bildausschnitt den linksseitig äußersten Punkt der Phasengrenze zwischen der Schmelzzone und dem wachsenden Einkristall. Dementsprechend bezeichnet die rechtsseitige Kante des wachsenden Einkristalls im ausgewerteten Bildausschnitt den rechtsseitig äußersten Punkt der Phasengrenze zwischen der Schmelzzone und dem wachsenden Einkristall.

Der Referenzpunkt liegt auf der Achse, die durch die Mitte des Keimkristalls führt.

Wächst der Einkristall wie vorgesehen, haben die linksseitige Kante und die rechtsseitige Kante jeweils den gleichen Abstand zum Referenzpunkt. Wenn die Achse, die durch die Mitte des wachsenden Einkristalls führt, relativ zur Achse, die durch die Mitte des Keimkristalls führt, gekippt ist, sind die entsprechenden Abstände nicht mehr gleich. Wegen der Drehung des Einkristalls schwanken diese Abstände über die Zeit betrachtet mit einer bestimmten Amplitude, deren Größe vom Ausmaß abhängt, mit welchem die Achse durch den wachsenden Einkristall gekippt ist.

Besonders bevorzugt ist es, den Mittelwert der Abstände von linksseitiger Kante und rechtsseitiger Kante zum Referenzpunkt zu bilden und die Amplitude der Schwankung des Mittelwerts als Messgröße heranzuziehen, um eine Störung des Wachstums des Einkristalls zu detektieren.

Die Verfahren gemäß der ersten und zweiten bevorzugten Ausführungsform der Erfindung können einzeln oder in beliebiger Kombination angewendet werden. Besonders bevorzugt ist es, die zwei Verfahren in Kombination anzuwenden.

Die Erfindung wird nachfolgend unter Bezugnahme auf Zeichnungen weiter erläutert.

**Kurzbeschreibung der Figuren**

**Fig.1** zeigt im Querschnitt einen wachsenden Einkristall, eine auf dem wachsenden Einkristall liegende Schmelzzone einschließlich eines Halses der Schmelzzone und eine Induktionsheizspule.

**Fig.2** zeigt in einem Diagramm den Verlauf einer Messgröße $h_{ZK}$, die den Anteil der Ziehkanten am Durchmesser des wachsenden Einkristalls ausdrückt, in Abhängigkeit der Zeit t.

**Fig.3** zeigt ein oberes Diagramm in der Art des Diagramms gemäß Fig.2 und in einem unteren Diagramm den Verlauf einer Messgröße $A_{MZ}$, die die Schwingungsamplitude der Schmelzzone ausdrückt, in Abhängigkeit der Zeit t.

**Fig.4** zeigt schematisch einen ersten wachsenden Einkristall, der mit korrekter Kristallorientierung wächst und einen zweiten wachsenden Einkristall, der mit Fehlorientierung wächst, nachdem dessen Mittelachse auf Grund eines Fehlers aus der üblichen vertikalen Ausrichtung gekippt wurde.

**Fig.5** ist eine Fig.1 entsprechende Zeichnung, wobei der wachsende Einkristall einen Halsabschnitt und einen konusförmigen Abschnitt und noch keinen Hauptabschnitt umfasst.

**Fig.6** zeigt in einem oberen Diagramm den zeitlichen Verlauf einer Messgröße $A_{MW}$ und in einem unteren Diagramm den Verlauf einer Stützkraft F in Abhängigkeit der Zeit t.

**Liste der verwendeten Bezugszeichen**

**1** wachsender Einkristall
**2** Schmelzzone
**3** Hals der Schmelzzone
**4** Induktionsheizspule
**5** Bildausschnitt (zweite bevorzugte Ausführungsform)
**6** Phasengrenze
**7** korrekt orientierter konusförmiger Abschnitt
**8** fehlorienterter konusförmiger Abschnitt
**9** Halsabschnitt angrenzend an Abschnitt 7
**10** Halsabschnitt angrenzend an Abschnitt 8
**11** durch die Mitte von Abschnitt 9 führende Achse
**12** durch die Mitte von Abschnitt 10 führende Achse

Detaillierte Beschreibung erfindungsgemäßer Ausführungsbeispiele

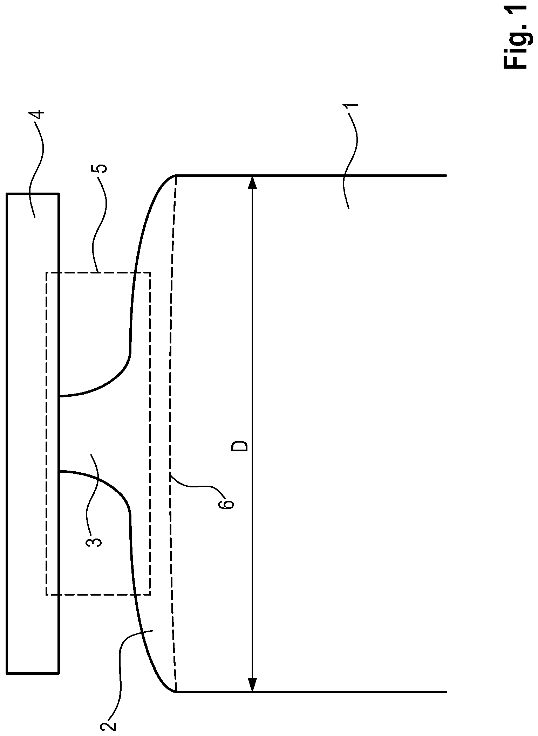

Fig.1 zeigt im Querschnitt einen wachsenden Einkristall 1, eine auf dem wachsenden Einkristall liegende Schmelzzone 2 einschließlich eines Halses 3 der Schmelzzone und eine Induktionsheizspule 4. Der Hauptabschnitt des wachsenden Einkristalls, der auf einen konusförmigen Abschnitt folgt, hat einen Durchmesser D, der über die Länge des Hauptabschnitts im Wesentlichen einheitlich ist.

Gemäß einer nicht erfindungsgemäßen Vorgehensweise wird der Durchmesser D bestimmt, indem ein Bildausschnitt von Bildern ausgewertet wird, der den Bereich um die Phasengrenze 6 zwischen der Schmelzzone 2 und dem wachsenden Einkristall 1 abbildet. Die Drehzahl des wachsenden Einkristalls und die Taktfrequenz der Aufnahme der Bilder werden unter Berücksichtigung der Regel (1) aufeinander abgestimmt.

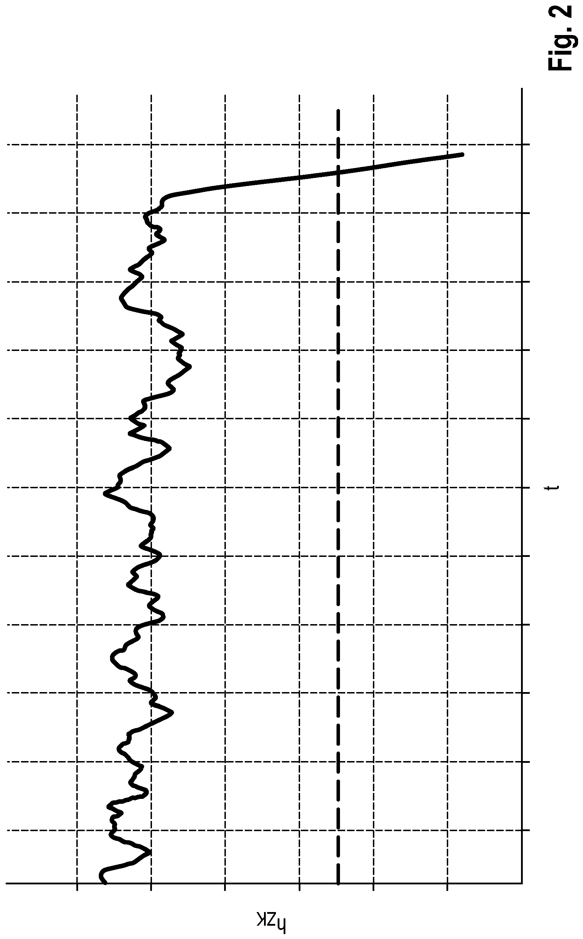

Fig.2 zeigt den zeitlichen Verlauf einer Messgröße $h_{ZK}$, der typisch ist für das Auftreten einer schweren Störung, auf die mit dem Abbruch des Kristallwachstums reagiert werden sollte. Die Messgröße $h_{ZK}$ drückt den Anteil der Ziehkanten am Durchmesser des wachsenden Einkristalls aus. Der steile Abfall der Messgröße unter die gesetzte eingezeichnete untere Schranke zeigt an, dass Ziehkanten nicht mehr beobachtet werden und der Kristall nicht mehr einkristallin wächst.

Gemäß der ersten bevorzugten Ausführungsform der Erfindung wird ein Bildausschnitt, beispielsweise der in Fig.1 eingezeichnete Bildausschnitt 5 ausgewertet, der einen oberen Teil der Schmelzzone 2 einschließlich eines Teils des Halses 3 der Schmelzzone und einen unteren Teil der Induktionsheizspule 4 umfasst. Durch Auswerten des Bildausschnitts wird als Messgröße eine Schwingungsamplitude der Schmelzzone bestimmt.

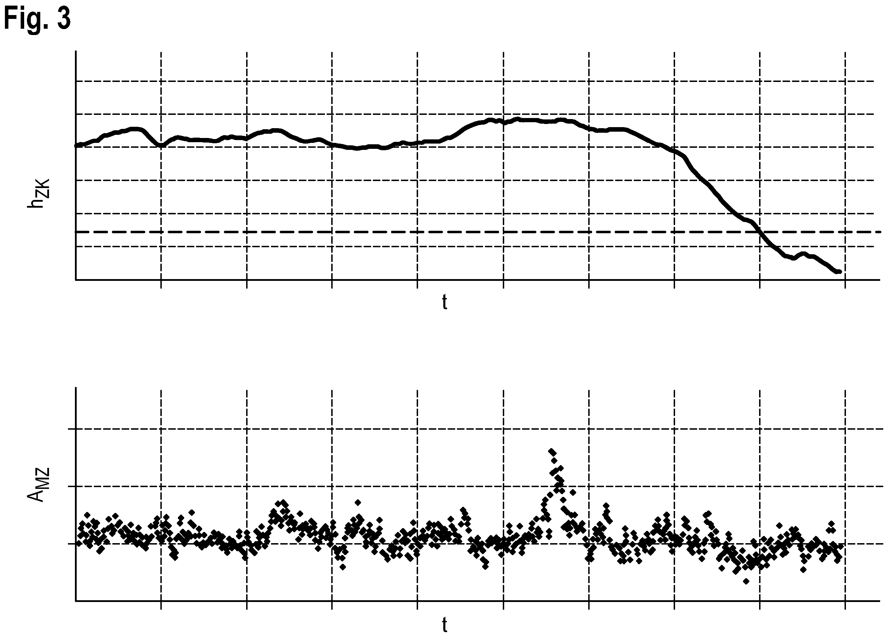

Das untere Diagramm von Fig.3 zeigt den zeitlichen Verlauf der Schwingungsamplitude $A_{MZ}$ und das obere Diagramm von Fig.3 zum Vergleich den zeitlichen Verlauf der Messgröße $h_{ZK}$. In beiden Diagrammen ist zu erkennen, dass eine jeweils eingezeichnete gesetzte Schwelle passiert wird. Allerdings wird im unteren Diagramm die Störung des Wachstums des Einkristalls deutlich früher angezeigt, als im oberen Diagramm.

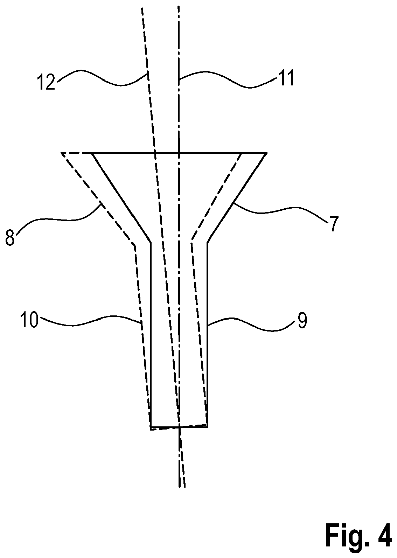

Fig.4 zeigt schematisch in vergleichender Darstellung einen korrekt orientiert wachsenden konusförmigen Abschnitt 7 eines wachsenden Einkristalls im Hintergrund und einen fehlorientiert wachsenden konusförmigen Abschnitt 8 eines anderen wachsenden Einkristalls im Vordergrund. Im Fall des korrekt orientierten Wachstums entspricht die durch die Mitte des konusförmigen Abschnitts 7 führende Achse im Wesentlichen der Achse 11 durch die Mitte eines Halsabschnittes (neck) 9 des wachsenden Einkristalls und der Achse durch die Mitte eines Keimkristalls (nicht dargestellt). Im Fall des fehlorientierten Wachstums ist die durch die Mitte des Halsabschnitts 10 führende Achse 12 relativ zu derjenigen des Keimkristalls gekippt. Das fehlorientierte Wachstum stellt eine Störung dar und ist Resultat eines Fehlers beim Abstützen des wachsenden Einkristalls mittels eines Rings, der von unten an den konusförmigen Abschnitt angelegt wird und eine bestimmte Stützkraft auf den wachsenden Einkristall über dessen Umfang ungleichmäßig verteilt ausübt.

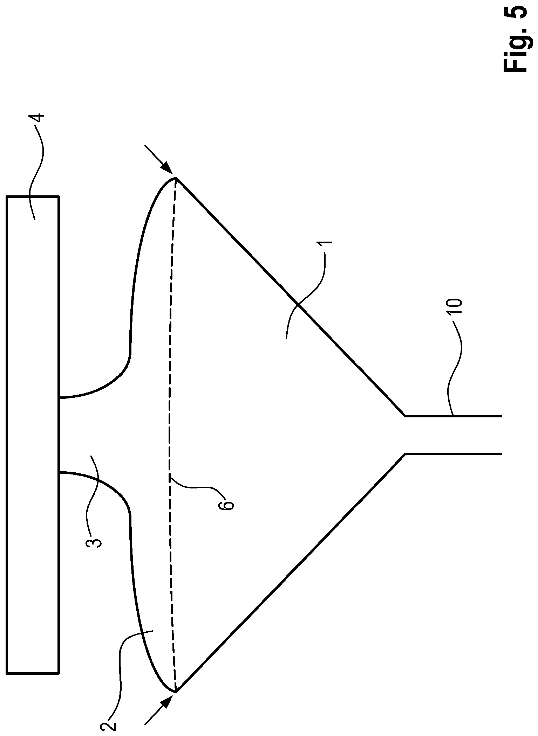

Gemäß der zweiten bevorzugten Ausführungsform der Erfindung wird ein Bildausschnitt umfassend einen Grenzbereich zwischen der Schmelzzone 2 und dem wachsenden Einkristall 1 ausgewertet und der Abstand zwischen einer linksseitigen Kante des wachsenden Einkristalls 1 und einem Referenzpunkt und der Abstand zwischen einer rechtsseitigen Kante des wachsenden Einkristalls und dem Referenzpunkt bestimmt. In Fig.5 zeigen kleine Pfeile zur linksseitigen und rechtsseitigen Kante des wachsenden Einkristalls 1.

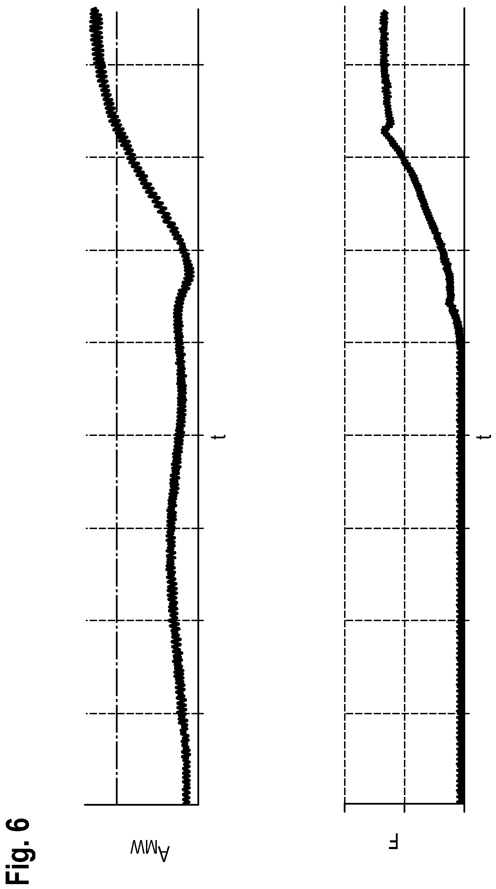

Im oberen Diagramm von Fig.6 ist der zeitliche Verlauf einer Messgröße $A_{MW}$ aufgetragen und im unteren Diagramm der Verlauf der Stützkraft F in Abhängigkeit der Zeit t. Die Messgröße $A_{MW}$ drückt die Amplitude aus, mit der der Mittelwert schwankt, der vom Abstand zwischen der linksseitigen Kante und dem Referenzpunkt und vom Abstand der rechtsseitigen Kante und dem Referenzpunkt gebildet wird. Das obere Diagramm zeigt einen Anstieg der Amplitude an, der mit einem Anstieg der Stützkraft korreliert und auf Grund dessen die Amplitude eine gesetzte Schwelle passiert hat.

## Patentansprüche

1. Verfahren zur Herstellung eines Einkristalls durch Zonenschmelzen, umfassend das Kristallisieren von geschmolzenem Material auf einem Keimkristall unter Bildung eines wachsenden Einkristalls;

das Drehen des wachsenden Einkristalls mit einer Drehzahl;
das Erzeugen und Erhalten einer auf dem wachsenden Einkristall liegenden Schmelzzone durch Schmelzen von festem Material in Gegenwart einer Induktionsheizspule;
das Aufnehmen mit einer Kamera von Bildern umfassend einen Teil der Schmelzzone;
das Bestimmen einer Messgröße durch Auswerten eines Bildausschnitts der aufgenommenen Bilder; und
das Erzeugen eines Warnsignals als Reaktion auf ein Ereignis, das eine Störung des Wachstums des Einkristalls bewirkt und/oder das Bewirken des Abbruchs des Kristallwachstums, sobald die Messgröße eine diesbezüglich gesetzte Schwelle passiert, wobei das Verfahren des Weiteren umfasst entweder

a) das Bestimmen einer Schwingungsamplitude der Schmelzzone durch Auswerten eines Bildausschnitts der aufgenommenen Bilder umfassend einen oberen Teil der Schmelzzone einschließlich eines Teils eines Halses der Schmelzzone und einen unteren Teil der Induktionsheizspule und das Erzeugen des Warnsignals und/oder das Bewirken des Abbruchs des Kristallwachstums, sobald die Schwingungsamplitude die diesbezüglich gesetzte Schwelle passiert, wobei zum Auswerten Grauwerte des Bildausschnitts eines Bilds mit denen eines Vorgängerbilds verglichen werden, der Betrag der Differenz der Grauwerte aufsummiert und normiert und als die Schwingungsamplitude der Schmelzzone interpretiert wird oder

b) das Bestimmen des Abstands zwischen einer linksseitigen Kante des wachsenden Einkristalls und einem Referenzpunkt, der auf einer Achse durch die Mitte des Keimkristalls liegt, und des Abstands zwischen einer rechtsseitigen Kante des wachsenden Einkristalls und dem Referenzpunkt durch Auswerten eines Bildausschnitts der aufgenommenen Bilder umfassend einen Grenzbereich zwischen der Schmelzzone und dem wachsenden Einkristall und

sobald die Amplitude einer Schwankung von mindestens einem der Abstände die diesbezüglich gesetzte Schwelle passiert, das Erzeugen des Warnsignals und/oder das Bewirken des Abbruchs des Kristallwachstums im Rahmen des Ausschöpfens eines Ermessensspielraums, der darin besteht, den Einkristall mit einer Fehlorientierung weiterwachsen zu lassen oder das Kristallwachstum abzubrechen.

**2.** Verfahren nach Anspruch 1, **gekennzeichnet durch** das Bilden des Mittelwerts der Abstände von linksseitiger Kante und rechtsseitiger Kante zum Referenzpunkt und das Heranziehen der Amplitude der Schwankung des Mittelwerts als Messgröße, um die Störung des Wachstums des Einkristalls zu detektieren.

**Claims**

**1.** A procedure of producing a single crystal by zone melting,

comprisingcrystallizing molten material on a seed crystal to form a growing single crystal;

the rotation of the growing single crystal at one speed;

the creation and maintenance of a melt zone lying on the growing single crystal by melting solid material in the presence of an induction heating coil;

taking pictures with a camera comprising a part of the melting zone;

determining a measurand by evaluating an image section of the captured images; and generating a warning signal in response to an event causing a disturbance of the growth of the single crystal and/or causing the cessation of the crystal growth as soon as the measured quantity passes a threshold set in this respect, the procedure further comprising either

a) Determining a vibration amplitude of the fusion zone by evaluating an image section of the captured images comprising an upper part of the fusion zone including a part of a neck of the fusion zone and a lower part of the induction heating coil and generating the warning signal and/or causing the termination of the crystal growth, as soon as the vibration amplitude passes the threshold set with respect thereto, wherein for evaluating gray values of the image section of an image are compared with those of a preceding image, the amount of the difference of the gray values is summed up and normalized and interpreted as the vibration amplitude of the melting zone or

b) determining the distance between a left-side edge of the growing single crystal and a reference point lying on an axis through the center of the seed crystal, and the distance between a right-side edge of the growing single crystal and the reference point by evaluating an image portion of the acquired images comprising a boundary region between the melting zone and the growing single crystal; and

as soon as the amplitude of a variation of at least one of the distances passes the threshold set in this respect, generating the warning signal and/or causing the termination of the crystal growth within the scope of exhausting a discretionary margin consisting in allowing the single crystal to continue growing with a misorientation or in terminating the crystal growth.

**2.** The procedure of claim 1, **characterized by** averaging the distances from the left-side edge and the right-side edge to the reference point and taking the amplitude of the variation of the average as a measurement to detect the disturbance of the growth of the single crystal.

**Revendications**

**1.** Procédé de production d'un monocristal par fusion de zone, comprenant la cristallisation d'un matériau fondu sur un cristal germe pour former un monocristal en croissance ;

la rotation du monocristal en croissance à une vitesse de rotation ;

la création et le maintien d'une zone de fusion reposant sur le monocristal en croissance par fusion d'un matériau solide en présence d'une bobine de chauffage par induction ;

la prise, à l'aide d'une caméra, d'images couvrant une partie de la zone de fusion ;

la détermination d'une grandeur de mesure par l'évaluation d'une partie d'image des images prises ; et

la génération d'un signal d'avertissement en réponse à un événement qui provoque une perturbation de la croissance du monocristal et/ou la réalisation de l'arrêt de la croissance du cristal dès que la grandeur mesurée passe un seuil fixé à cet effet, le procédé comprenant en outre soit

a) Déterminer une amplitude d'oscillation de la zone de fusion en évaluant une partie d'image des images capturées comprenant une partie supérieure de la zone de fusion comprenant une partie d'un col de la zone de fusion et une partie inférieure de la bobine de chauffage par induction et générer le signal d'avertissement et/ou provoquer l'arrêt de la croissance du cristal, dès que l'amplitude d'oscillation passe le seuil fixé à cet effet, des valeurs de gris de la partie d'image d'une image étant comparées à celles d'une image précédente pour l'évaluation, la valeur de la différence des valeurs de gris étant additionnée et normalisée et interprétée comme l'amplitude d'oscillation de la zone de fusion ou

b) La détermination de la distance entre un bord gauche du monocristal en croissance et un point de référence situé sur un axe passant par le centre du cristal germe et de la distance entre un bord droit du monocristal en croissance et le point de référence en évaluant une partie d'image des images capturées comprenant une région limite entre la zone de fusion et le monocristal en croissance ; et

dès que l'amplitude d'une variation d'au moins l'une des distances passe le seuil fixé à cet égard, la production du signal d'avertissement et/ou la réalisation de l'arrêt de la croissance du cristal dans le cadre de l'utilisation d'une marge d'appréciation consistant à laisser le monocristal continuer à croître avec une mauvaise orientation ou à arrêter la croissance du cristal.

2. Procédé selon la revendication 1, **caractérisé par** le calcul de la moyenne des distances entre le bord gauche et le bord droit par rapport au point de référence et par l'utilisation de l'amplitude de la variation de la moyenne comme grandeur de mesure pour détecter la perturbation de la croissance du monocristal.

Fig. 1

EP 3 279 372 B1

Fig. 2

Fig. 3

**Fig. 4**

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0294311 A1
- JP 11278981 A

- JP 9208381 A

**In der Beschreibung aufgeführte Nicht-Patentliteratur**

- COMPUTER-CONTROLLED FLOAT ZONE CRYSTAL GROWTH. **CHAN Y. T.** REVIEW OF SCIENTIFIC INSTRUMENTS. 01. September 1993, vol. 64, 2643-2649